# EUROPEAN PATENT APPLICATION

(11) **EP 4 516 973 A1**
(43) Date of publication of application: **05.03.2025**
(21) Application number: 23795915.0
(22) Date of filing: 06.03.2023
(51) Int. Cl.: C30B 29/04, C23C 16/27, C30B 25/18

(54) **SUBSTRATE WITH DEPOSITED DIAMOND FILM AND METHOD FOR PRODUCING SUBSTRATE WITH DEPOSITED DIAMOND FILM**

(30) Priority: 26.04.2022 JP 2022072370
(71) Applicant: Sumitomo Chemical Company, Limited, Tokyo 103-6020 (JP)
(72) Inventor: NISHIKAWA, Naohiro, Hitachi-shi, Ibaraki 319-1418 (JP); MORITA, Toshiaki, Hitachi-shi, Ibaraki 319-1418 (JP); KURIHARA, Kaori, Hitachi-shi, Ibaraki 319-1418 (JP)
(74) Representative: Vossius & Partner Patentanwälte Rechtsanwälte mbB
(86) International application number: PCT/JP2023/008214
(87) International publication number: WO 2023/210167

(57) **Abstract**

There is provided a diamond film-deposited substrate, including: a substrate comprising niobium metal; a niobium carbide layer on at least one main surface of the substrate; and a conductive diamond film on the niobium carbide layer,
wherein when a surface of the conductive diamond film was observed using a scanning electron microscope, no pinholes reaching the substrate or the niobium carbide layer are present within a field of view of 20 µm×20 µm.

## Description

### Technical Field

The present invention relates to a diamond film-deposited substrate and a method for manufacturing a diamond film-deposited substrate.

### Description of Related Art

Conductive diamond has a wide potential window in both aqueous and nonaqueous systems, with small background current, thus making it known as an electrode material capable of performing highly sensitive electrochemical detection over a wide potential range.

For example, Patent document 1 discloses a method for manufacturing a conductive diamond electrode, including: applying plastic treatment to at least a surface of an electrode substrate comprising a material such as valve metals selected from the group consisting of niobium, tantalum, titanium and zirconium, and alloys based on these metals; next, applying heat treatment to the electrode substrate in a vacuum or in an inert atmosphere; and forming a conductive diamond film on a surface of the heat-treated electrode substrate.

### Prior art document

### Patent document

[Patent Document 1] Patent publication No. 4456378

### Summary of the invention

### Problem to be solved by the invention

An object of the present invention is to provide a diamond film-deposited substrate capable of improving the durability of a diamond electrode.

### Means for solving the problem

According to an aspect of the present invention, there is provided a diamond film-deposited substrate, including:
a substrate comprising niobium metal;
a niobium carbide layer on at least one main surface of the substrate; and
a conductive diamond film on the niobium carbide layer,
wherein when a surface of the conductive diamond film is observed using a scanning electron microscope, no pinholes reaching the substrate or the niobium carbide layer are present within a field of view of 20 µm×20 µm.

According to another aspect of the present invention, there is provided a method for manufacturing a diamond film-deposited substrate, the method including:
forming a processing damage layer having microcracks by introducing processing damage onto at least one main surface of a substrate comprising niobium metal;
embedding a carbon source comprising a solid carbon or carbon compound into the processing damage layer;
applying a heat treatment to the processing damage layer to cause a reaction between the niobium metal and the carbon source to form a niobium carbide layer continuously covering the main surface; and
depositing a conductive diamond film on the niobium carbide layer.

### Advantage of the invention

According to the present invention, it is possible to provide a diamond film-deposited substrate capable of improving the durability of a diamond electrode.

### Brief description of the drawings

FIG. 1 is a schematic view illustrating a cross section of a diamond film-deposited substrate 10 according to a first embodiment of the present invention.
FIG. 2 is a flow chart showing an example of a method for manufacturing the diamond film-deposited substrate 10 according to the first embodiment of the present invention.
FIG. 3(a) is a schematic view illustrating a processing damage layer forming step S102 according to the first embodiment of the present invention, and FIG. 3(b) is a schematic view illustrating a carbon source embedding step S103 according to the first embodiment of the present invention.
FIG. 4 is a schematic view illustrating a cross section of the diamond film-deposited substrate 10 according to a modified example of the first embodiment of the present invention.
FIG. 5(a) is a surface photograph of Sample 1 according to an example of the present invention, FIG. 5(b) is a surface photograph of Sample 2 according to an example of the present invention, FIG. 5(c) is a surface photograph of Sample 3 according to an example of the present invention, and FIG. 5(d) is a surface photograph of Sample 4 according to an example of the present invention.

### Detailed description of the invention

### <Finding obtained by the present inventors>

First, the finding obtained by the present inventors will be described.

A diamond electrode that has been made conductive by doping it with boron, etc., can be used to generate oxidizing agents such as ozone. Durability is a major issue for such a diamond electrode. Although the technique described in Patent document 1, etc., has improved the adhesion and peel strength between a substrate and a diamond film, it has been found that it is difficult to obtain a practical level of durability.

For example, paragraph 0009 of Patent document 1 states that "when an intermediate layer is made of carbide derived from a substrate, it is expected that the adhesion of a diamond film will be improved due to a relationship between the substrate and the carbide growing from the substrate, and a relationship between a carbide and a diamond generated with the carbide as a nucleus. However, in reality, carbides often have inferior corrosion resistance to oxides when a potential is applied to them as an anode in a strong acidic environment. Carbide is likely to be formed on the substrate when it comes into contact with hydrocarbon radicals or diamond at a high temperature, so care must be taken when using it as an anode." From the viewpoint of improving durability, it has been considered preferable to prevent as much carbide as possible from being formed on the intermediate layer between the substrate and the diamond film.

The present inventors have conducted extensive research into the above-described carbide layer. As a result, it was found that the carbide layer only inhibits the durability of the diamond electrode when it comes into contact with a strongly acidic liquid, and that the essence of the problem is the presence of pinholes on the surface of the diamond film that reach the substrate or the carbide layer. It was also found that an occurrence of the pinholes can be suppressed by intentionally forming a continuous carbide layer as an intermediate layer. In order to form the continuous carbide layer, for example, it has been found to be effective to introduce processing damage into a substrate to form a processing damage layer having microcracks, embed a carbon source in the processing damage layer, and then apply a heat treatment thereto.

### [Details of the embodiment of the present invention]

Next, an embodiment of the present invention will be described below with reference to the drawings. The present invention is not limited to these embodiments, but is defined by the claims, and is intended to include all modifications within the meaning and scope of the claims.

### <First embodiment of the present invention>

### (1) Configuration of a diamond film-deposited substrate 10

First, the configuration of the diamond film-deposited substrate 10 of this embodiment will be described. The diamond film-deposited substrate 10 of this embodiment is preferably used for manufacturing a diamond electrode for an electrochemical reaction (for example, for ozone generation). This makes it possible to suppress deterioration of the diamond electrode due to electrical conduction and improve its durability.

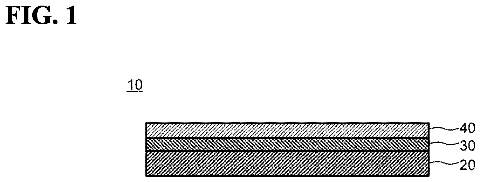

FIG. 1 is a schematic view illustrating the cross section of the diamond film-deposited substrate 10 according to this embodiment. As illustrated in FIG. 1, the diamond film-deposited substrate 10 includes, for example, a substrate 20, a niobium carbide layer 30, and a conductive diamond film 40.

The substrate 20 is, for example, a flat niobium metal plate material for depositing the conductive diamond film 40 and for supporting the conductive diamond film 40. The size and thickness of the main surface of the substrate 20 are not particularly limited, but for example, the main surface has a rectangular shape with one side measuring 20 mm to 500 mm, and a thickness measuring 0.5 mm to 5 mm.

The niobium carbide layer 30 is formed, for example, on at least one main surface of the substrate 20, and is a layer formed by a reaction between a part of the niobium metal of the substrate 20 and a carbon source 22 described below. The niobium carbide layer 30 functions, for example, as an intermediate layer to increase a nucleation density of diamond crystals.

The thickness of the niobium carbide layer 30 is preferably, for example, 0.5 µm or more and 5 µm or less (more preferably 0.8 µm or more and 2.5 µm or less). That is, a maximum thickness and a minimum thickness of the niobium carbide layer 30 are preferably within a range of 0.5 µm or more and 5 µm or less (more preferably, 0.8 µm or more and 2.5 µm or less). When the thickness of the niobium carbide layer 30 is less than 0.5 µm, the nucleation density of the diamond crystals for forming the conductive diamond film 40 may be insufficient. Meanwhile, by setting the thickness of the niobium carbide layer 30 to 0.5 µm or more, the nucleation density of the diamond crystals for forming the conductive diamond film 40 can be sufficiently increased. On the other hand, when the thickness of the niobium carbide layer 30 exceeds 5 µm, an internal stress increases, and there is a possibility that the diamond film-deposited substrate 10 will be warped. Meanwhile, by setting the thickness of the niobium carbide layer 30 to 5 µm or less, the internal stress can be reduced, and warping of the diamond film-deposited substrate 10 can be reduced.

The conductive diamond film 40 is, for example, a polycrystalline film having electrical conductivity that is formed on the niobium carbide layer 30. The conductive diamond film 40 may be either a polycrystalline diamond film or a diamond-like carbon (DLC) film. The conductive diamond film 40 preferably contains, for example, boron at a concentration of 1×10¹⁹ cm⁻³ or more and 1×10²² cm⁻³ or less. The thickness of the conductive diamond film 40 is, for example, 0.5 µm or more and 10 µm or less, and from the viewpoint of maintaining a balance between durability and cost, it is preferably 1 µm or more and 5 µm or less. This embodiment shows a case in which the conductive diamond film 40 has a single layer structure.

When the surface of the conductive diamond film 40 is observed using, for example, a scanning electron microscope (for example, 5000 times magnification), no pinholes reaching the substrate 20 or the niobium carbide layer 30 are present within a 20 µm×20 µm field of view. Therefore, it is possible to reduce the risk of the strongly acidic liquid coming into contact with the niobium carbide layer 30 even when the diamond electrode is used in a strongly acidic liquid, for example, and possible to improve the durability of the diamond electrode. From the viewpoint of further improving the durability of the diamond electrode, it is preferable that no pinholes reaching the substrate 20 or the niobium carbide layer 30 are present within a field of view of 1 mm×1 mm, and it is particularly preferable that no pinholes are present over an entire surface of the conductive diamond film 40.

Further, when the cross section (longitudinal or transverse section) of the conductive diamond film 40 is observed using, for example, a scanning electron microscope (for example, 5000 times magnification), it is preferable that no pinholes reaching the substrate 20 or the niobium carbide layer 30 are present within a 20 µm×20 µm field of view. That is, in the conductive diamond film 40, not only pinholes observable from the surface but also internal pinholes are reduced. Thereby, the durability of the diamond electrode can be further improved. It is more preferable that no pinholes reaching the substrate 20 or the niobium carbide layer 30 are present within a field of view of 1 mm×1 mm in the cross section (longitudinal or transverse section) of the conductive diamond film 40, and it is particularly preferable that no pinholes are present over an entire cross section of the conductive diamond film 40.

When the cross section of the diamond film-deposited substrate 10 is observed using, for example, a scanning electron microscope (for example, 5000 times magnification), it is preferable that a continuous niobium carbide layer 30 having a thickness of 0.5 µm or more is formed over a width (length in a direction parallel to the main surface of the substrate 20) of 20 µm or more. Thereby, the nucleation density of the diamond crystals for forming the conductive diamond film 40 can be increased and the occurrence of pinholes can be suppressed. From the viewpoint of further suppressing the occurrence of pinholes, it is more preferable that a continuous niobium carbide layer 30 having a thickness of 0.5 µm or more is formed over a width of 1 mm or more, and it is particularly preferable that a continuous niobium carbide layer 30 having a thickness of 0.5 µm or more is formed over an entire main surface of the substrate 20.

The main component of the niobium carbide layer 30 is preferably niobium carbide, for example, having a chemical formula NbC. Thereby, the nucleation density of the diamond crystals for forming the conductive diamond film 40 can be increased. The main component of the niobium carbide layer 30 can be confirmed by, for example, X-ray diffraction (XRD).

The crystallite size of the niobium carbide contained in the niobium carbide layer 30 is preferably, for example, 1 nm or more and 60 nm or less. When the crystallite size is outside the above range, it may be difficult to form the continuous niobium carbide layer 30 having a thickness of 0.5 µm or more. In contrast, with the crystallite size within the above range, the continuous niobium carbide layer 30 having a thickness of 0.5 µm or more is easily formed, and as a result, the occurrence of pinholes is easily suppressed. In this specification, each crystallite size can be measured, for example, by the Scherrer method of XRD. When the diamond film-deposited substrate 10 is measured by XRD, peaks of NbC (111), NbC (200), NbC (222), NbC (400), etc., are observed, with the NbC (111) peak being the strongest. Therefore, in this specification, unless otherwise specified, the crystallite size of niobium carbide was calculated from the peak of NbC (111).

The crystallite size of the niobium metal contained in the substrate 20 (particularly the niobium metal present in the vicinity of an interface with the niobium carbide layer 30) is preferably, for example, 30 nm or more and 90 nm or less. When the crystallite size of the niobium metal is less than 30 nm, it may be difficult to form the continuous niobium carbide layer 30. Meanwhile, by setting the crystallite size of the niobium metal to 30 nm or more, the continuous niobium carbide layer 30 is easily formed. On the other hand, when the crystallite size of the niobium metal exceeds 90 nm, the difference in crystallite size with respect to the niobium carbide contained in the niobium carbide layer 30 becomes large, and cracks, etc., may occur. Meanwhile, by setting the crystallite size of the niobium metal to 90 nm or less, the crystallite size is distributed so as to gradually decrease from the substrate 20 to the niobium carbide layer 30, so the occurrence of cracks, etc., can be suppressed. When the diamond film-deposited substrate 10 is measured by XRD (from the conductive diamond film 40 side), peaks such as Nb (110), Nb (200), and Nb (211) are observed, with the Nb (110) peak being the strongest. Therefore, in this specification, unless otherwise specified, the crystallite size of the niobium metal was calculated from the peak of Nb (110).

### (2) Method for manufacturing a diamond film-deposited substrate 10

Next, a method for manufacturing the diamond film-deposited substrate 10 of this embodiment will be described. As described above, the diamond film-deposited substrate 10 of this embodiment can be used to manufacture a diamond electrode for an electrochemical reaction (e.g., for ozone generation). Therefore, the present invention is also applicable as a method for manufacturing a diamond electrode.

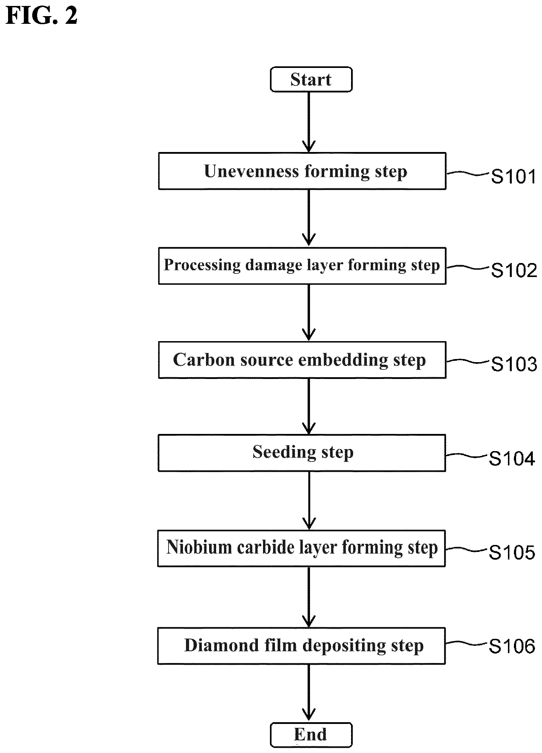

FIG. 2 is a flow chart showing an example of the method for manufacturing a diamond film-deposited substrate 10 of this embodiment. As shown in FIG. 2, the method for manufacturing a diamond film-deposited substrate 10 of this embodiment includes, for example, an unevenness forming step S101, a processing damage layer forming step S102, a carbon source embedding step S103, a seeding step S104, a niobium carbide layer forming step S105, and a diamond film depositing step S106. This embodiment shows a case in which the diamond film-deposited substrate 10 is manufactured from the substrate 20 comprising niobium metal.

### (Unevenness forming step S101)

The unevenness forming step S101 is, for example, a step of performing processing to form unevenness on at least one main surface of the substrate 20. Thereby, peeling caused by a difference in thermal expansion coefficient between the substrate 20 and the conductive diamond film 40, can be suppressed. That is, a peel strength of the diamond film-deposited substrate 10 can be further improved. In the unevenness forming step S101, it is preferable to form the unevenness so that the arithmetic mean roughness Ra (see JIS B0601-2001) of the main surface is 0.5 µm or more and 10 µm or less. The processing for forming the unevenness can be performed by a known method such as grinding, blasting, wet etching, and dry etching.

The unevenness forming step S101 is preferably performed, for example, before the processing damage layer forming step S102. When the processing for forming unevenness is performed to the surface on which the processing damage layer 21 is formed, there is a possibility that the processing damage layer 21 will be removed. Meanwhile, by performing the unevenness forming step S101 before the processing damage layer forming step S102, work-hardening occurs in the substrate 20, and therefore microcracks are likely to be formed in the processing damage layer forming step S102. Further, in the unevenness forming step S101, in order to further work-harden the substrate 20, further machining such as punching or grooving may be performed.

The unevenness forming step S101 may be omitted. In the method for manufacturing the diamond film-deposited substrate 10 according to this embodiment, even when the unevenness forming step S101 is omitted, by performing the processing damage layer forming step S102 and the carbon source embedding step S103 described later, the niobium carbide layer 30 that continuously covers the main surface of the substrate 20 can be formed in the niobium carbide layer forming step S105. That is, the occurrence of pinholes on the conductive diamond film 40 can be suppressed.

### (Processing damage layer forming step S102)

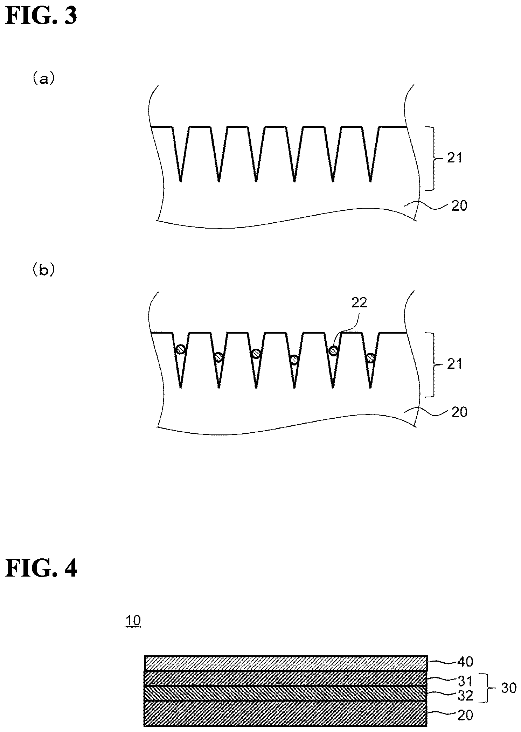

FIG. 3(a) is a schematic view illustrating the processing damage layer forming step S102. As illustrated in FIG. 3(a), the processing damage layer forming step S102 is a step of forming a processing damage layer 21 having a large number of microcracks by introducing processing damage onto at least one main surfaces of the substrate 20 (the surface on which unevenness is formed at least in the unevenness forming step S101). In order to dissolve carbon in niobium metal and form niobium carbide, heating to over 2300 degrees is usually required, but by forming the processing damage layer 21, the diffusion of carbon atoms into the niobium metal is promoted even at a low temperature (for example, about 800 degrees), and the niobium carbide layer 30 becomes easier to be formed. The method for introducing processing damage is not particularly limited as long as it is a method capable of forming microcracks. Specifically, processing damage can be introduced by grinding, imprinting, blasting, pressing, etc., to form the processing damage layer 21 having microcracks. In this specification, the microcracks include not only cracks having a length of 0.1 µm or more and 2 µm or less and a width of 5 nm or more and 200 nm or less (hereinafter, this will also be referred to as microcracks with voids), but also grain boundaries where crystal defects are gathered and arranged at a high density (hereinafter, this will also be referred to as microcracks without voids). That is, the microcracks as used herein do not necessarily involve voids. Microcracks can be confirmed, for example, by observing the main surface of the substrate 20 with a scanning electron microscope. Further, in the processing damage layer forming step S102, for example, it is preferable to form microcracks having a depth of 0.5 µm or more and 5 µm or less at a density of 10⁸ /cm² or more and 10⁹ /cm² or less. Thereby, the carbon source 22 can be more easily embedded inside the microcracks in the carbon source embedding step S103 described later.

In the processing damage layer forming step S102, for example, it is preferable to form the processing damage layer 21 with a thickness of 0.5 µm or more and 5 µm or less (more preferably, 0.8 µm or more and 2.5 µm or less). In the niobium carbide layer forming step S105 described later, at least a part of the processing damage layer 21 becomes the niobium carbide layer 30, so by setting the thickness of the processing damage layer 21 within the above range, it becomes easier to form the niobium carbide layer 30 with an appropriate thickness. When the thickness of the processing damage layer 21 is specified, for example, the processing damage layer 21 may be formed as a region in which the crystallite size is 10% or more smaller than the crystallite size of the niobium metal before the processing damage layer 21 is formed.

In the processing damage layer forming step S102, for example, it is preferable to introduce processing damage so that the crystallite size of the niobium metal in the processing damage layer 21 is 1 nm or more and 25 nm or less. When the crystallite size of the niobium metal in the processing damage layer 21 exceeds 25 nm, the carbon source 22 is unlikely to diffuse into the processing damage layer 21, and it may be difficult to form a continuous niobium carbide layer 30. In contrast, by setting the crystallite size of the niobium metal in the processing damage layer 21 to 25 nm or less, the surface area of the niobium metal becomes sufficiently large, making it easier to form the continuous niobium carbide layer 30. Further, even when the crystallite size of the niobium metal in the processing damage layer 21 is less than 1 nm, it is technically difficult to decrease the crystallite size of niobium metal to less than 1 nm, and the cost increases significantly although it is possible to form the continuous niobium carbide layer 30. Therefore, from the viewpoint of cost reduction, the crystallite size of the niobium metal in the processing damage layer 21 is preferably 1 nm or more.

### (Carbon source embedding step S103)

FIG. 3(b) is a schematic view illustrating the carbon source embedding step S103. As illustrated in FIG. 3(b), the carbon source embedding step S103 is a step of embedding a carbon source 22 comprising a solid carbon or carbon compound inside the processing damage layer 21 (for example, inside microcracks with voids). Since the processing damage layer 21 has a large number of microcracks, the carbon source 22 can be easily embedded therein. Specifically, for example, the surface of the substrate 20 is sprinkled with the carbon source 22, and the surface is rubbed against another substrate 20 of the same size, whereby the carbon source 22 is embedded while being crushed until it is approximately the same size as the microcracks (for example, average particle size of 200 nm or less). Further, since the carbon source 22 is a solid, carbon atoms can be introduced into the processing damage layer 21 at a high concentration compared to a hydrocarbon gas, etc. This makes it easier for the carbon atoms to diffuse into the niobium metal of the processing damage layer 21, making it easier to form the continuous niobium carbide layer 30.

As the carbon source 22, for example, graphite, boron carbide, diamond powder, etc., can be used. When diamond powder is used as the carbon source 22, in order to enhance the reactivity with niobium metal, it is preferable to use diamond powder with at least its outer circumference covered with an amorphous layer (sp² carbon). From the viewpoint of enhancing the reactivity with niobium metal and reducing a cost, it is preferable to use graphite as the carbon source 22.

An average particle size of the carbon source 22 is preferably 200 nm or less. Thereby, it becomes easier to embed the carbon source 22 inside the processing damage layer 21. Further, the surface area of the carbon source 22 is increased, and the reactivity with niobium metal can be improved. A lower limit of the average particle size of the carbon source 22 is not particularly limited, but is, for example, 5 nm or more.

In the carbon source embedding step S103, when graphite (average particle size: 5 to 200 nm) is embedded in the processing damage layer 21 as the carbon source 22, for example, it is preferable to embed the carbon source 22 of 0.1 µg/cm² or more and 10 µg/cm² or less. When the amount of the embedded carbon source 22 is less than 0.1 µg/cm², the carbonization of the niobium metal will be insufficient, and it may be difficult to form the continuous niobium carbide layer 30. In contrast, by setting the amount of the embedded carbon source 22 to 0.1 µg/cm² or more, the niobium metal is sufficiently carbonized, and the continuous niobium carbide layer 30 is easily formed. On the other hand, when the amount of the embedded carbon source 22 exceeds 10 µg/cm², a large amount of carbon source 22 remains after the formation of the niobium carbide layer 30, which may adversely affect the deposition of the conductive diamond film 40. In contrast, by setting the amount of the embedded carbon source 22 to 10 µg/cm² or less, the amount of a residual carbon source 22 can be reduced. Further, from the viewpoint of reducing an energy (cost) required for embedding the carbon source 22, it is preferable to embed the carbon source 22 to a depth of 1 µm or less. When checking the carbon source 22 inside the processing damage layer 21, for example, the cross-section of the processing damage layer 21 (for example, at a depth of about 1 µm) may be observed using a transmission electron microscope.

### (Seeding step S104)

The seeding step S104 is, for example, a step of seeding diamond particles on the main surface of the substrate 20 (the main surface on which the processing damage layer 21 is formed, that is, the surface of the processing damage layer 21). By having the diamond particles present at an interface between the niobium carbide layer 30 and the conductive diamond film 40, an energy barrier required for initial nucleation to form the conductive diamond film 40 can be lowered. The method for seeding with diamond particles can be a known method such as blasting or immersion.

The seeding step S104 is preferably performed, for example, before the niobium carbide layer 30 is formed (that is, before the niobium carbide layer forming step S105). This allows the niobium carbide layer forming step S105 and the diamond film depositing step S106, which will be described later, to be performed continuously within the same apparatus. Further, in this case, the seeding step S104 may be performed simultaneously with the carbon source embedding step S103 described above. That is, the carbon source 22 used in the carbon source embedding step S103 and the diamond particles used in the seeding step S104 can be the same diamond particles. As described above, the carbon source 22 preferably contains sp² carbon. Accordingly, diamond particles (e.g., nanodiamond particles obtained by detonation method) in which the circumference of a diamond structure (sp³ structure) core part is covered with an amorphous layer (sp² carbon) are preferable because the sp² carbon is consumed during the formation of the niobium carbide layer 30, leaving the sp³ core as a seeded diamond particle.

The seeding step S104 may be omitted. Even when the seeding step S104 is omitted, by performing the above-described processing damage layer forming step S102 and carbon source embedding step S103, the niobium carbide layer 30 that continuously covers the main surface of the substrate 20 can be formed in the niobium carbide layer forming step S105. That is, the occurrence of pinholes on the conductive diamond film 40 can be suppressed.

### (Niobium carbide layer forming step S105)

The niobium carbide layer forming step S105 is a step of forming a niobium carbide layer 30 that continuously covers the main surface of the substrate 20 by applying heat treatment to the processing damage layer 21 and causing the niobium metal to react with the carbon source 22. Thereby, the occurrence of pinholes on the surface of the conductive diamond film 40, can be suppressed. In the niobium carbide layer forming step S105, a structure is reconstructed at the same time as the niobium carbide layer 30 is formed, and most of the microcracks formed in the processing damage layer forming step S102 disappear. Further, in the processing damage layer 21 that remains without reacting with the carbon source 22, the processing damage is recovered to a certain extent and the strength is increased, because defects disappear and decrease due to solid-phase diffusion at grain boundaries.

In the niobium carbide layer forming step S105, for example, a hot filament CVD apparatus described later can be used as a heating furnace for heat treatment to form the niobium carbide layer 30.

The conditions for the heat treatment in the niobium carbide layer forming step S105 are, for example, as follows.
Heat treatment temperature (substrate temperature): 550 to 850 degrees
Pressure: 10 to 50 Torr
Heat treatment time: 30 to 120 minutes

In the niobium carbide layer forming step S105, it is preferable to form the niobium carbide layer 30 having a thickness of, for example, 10% to 100% (more preferably, 30% to 100%) of the processing damage layer 21. In other words, it is preferable that a depth range from the surface to 10% or more of the thickness of the processing damage layer 21 is reacted with the carbon source 22 to form the niobium carbide layer 30. When the thickness of the niobium carbide layer 30 is less than 10% of the thickness of the processing damage layer 21, the nucleation density of the diamond crystals will be insufficient, which may cause pinholes. In contrast, by setting the thickness of the niobium carbide layer 30 to 10% or more of the thickness of the processing damage layer 21, the nucleation density of the diamond crystals can be sufficiently increased. When an entire damaged layer 21 is reacted with the carbon source 22, the thickness of the niobium carbide layer 30 becomes equal to the thickness of the damaged layer 21.

In the niobium carbide layer forming step S105, for example, it is preferable to form the niobium carbide layer 30 containing niobium carbide of the chemical formula NbC as a main component. Thereby, the nucleation density of the diamond crystals for forming the conductive diamond film 40, can be increased.

In the niobium carbide layer forming step S105, for example, it is preferable to form the niobium carbide layer 30 so that the crystallite size of the niobium carbide contained in the niobium carbide layer 30 is 1 nm or more and 60 nm or less. Thereby, it becomes easier to prevent pinholes from occurring.

### (Diamond film depositing step S106)

The diamond film depositing step S106 is, for example, a step of depositing a conductive diamond film 40 on the niobium carbide layer 30. According to this embodiment, the continuous niobium carbide layer 30 is formed in the above-described niobium carbide layer forming step S105, and therefore the occurrence of pinholes on the surface of the conductive diamond film 40 can be suppressed. In the diamond film depositing step S106, the conductive diamond film 40 can be deposited using, for example, a hot filament CVD apparatus. The hot filament CVD apparatus is configured so as to be able to supply various gases, such as hydrogen gas, carbon-containing gas, and boron-containing gas, to a growth chamber. The carbon-containing gas may be methane gas or ethane gas. The boron-containing gas may be trimethylboron (TMB) gas, trimethylborate gas, triethylborate gas, or diborane gas. Further, the hot filament CVD apparatus includes a temperature sensor, a tungsten filament, an electrode (for example, a molybdenum electrode) etc., in an airtight container arranged inside the growth chamber.

Diamond crystal growth conditions in the diamond film depositing step S106 are exemplified as follows.
Heat treatment temperature (substrate temperature): 700 to 1000 degrees
Pressure: 5 to 50 Torr
Heat treatment time: 1 to 10 hours

By the above steps, the diamond film-deposited substrate 10 can be manufactured. Also, the diamond film-deposited substrate 10 may be divided into pieces of a predetermined size to manufacture a plurality of diamond electrodes.

### (3) Effects of this embodiment

According to this embodiment, one or more of the following effects are achieved.

(a) In the diamond film-deposited substrate 10 of this embodiment, when the surface of the conductive diamond film 40 is observed using, for example, a scanning electron microscope, no pinholes reaching the substrate 20 or the niobium carbide layer 30 are present within a field of view of 20 µm×20 µm. Thereby, even when a diamond electrode is used in a strongly acidic liquid, for example, the risk of the strongly acidic liquid coming into contact with the niobium carbide layer 30 can be reduced, thereby making it possible to improve the durability of the diamond electrode. From the viewpoint of further improving the durability of the diamond electrode, it is preferable that no pinholes reaching the substrate 20 or the niobium carbide layer 30 are present within a field of view of 1 mm × 1 mm, and it is particularly preferable that no pinholes are present over an entire surface of the conductive diamond film 40.
   Specifically, for example, when a diamond electrode for generating ozone water is manufactured using the diamond film-deposited substrate 10 of this embodiment, deterioration of the diamond electrode due to electrical conduction can be suppressed, and peeling of the conductive diamond film 40 can be prevented. That is, the durability of the diamond electrode can be improved.
(b) In the diamond film-deposited substrate 10 of this embodiment, when the cross section of the diamond film-deposited substrate 10 is observed using, for example, a scanning electron microscope, it is preferable that a continuous niobium carbide layer 30 having a thickness of 0.5 µm or more is formed over a width of 20 µm or more. Thereby, the nucleation density of diamond crystals for forming the conductive diamond film 40 can be sufficiently increased and the occurrence of pinholes can be suppressed. From the viewpoint of further suppressing the occurrence of pinholes, it is more preferable that the continuous niobium carbide layer 30 having a thickness of 0.5 µm or more is formed over a width of 1 mm or more, and it is particularly preferable that the continuous niobium carbide layer 30 having a thickness of 0.5 µm or more is formed over an entire main surface of the substrate 20.
(c) In the diamond film-deposited substrate 10 of this embodiment, the thickness of the niobium carbide layer 30 is preferably, for example, 0.5 µm or more and 5 µm or less (more preferably 0.8 µm or more and 2.5 µm or less). That is, a maximum thickness and a minimum thickness of the niobium carbide layer 30 are preferably within a range of 0.5 µm or more and 5 µm or less (more preferably, 0.8 µm or more and 2.5 µm or less). When the thickness of the niobium carbide layer 30 is less than 0.5 µm, the nucleation density of the diamond crystals for forming the conductive diamond film 40 may be insufficient. In contrast, by setting the thickness of the niobium carbide layer 30 to 0.5 µm or more, the nucleation density of the diamond crystals for forming the conductive diamond film 40 can be sufficiently increased. On the other hand, when the thickness of the niobium carbide layer 30 exceeds 5 µm, the internal stress increases, and there is a possibility that the diamond film-deposited substrate 10 will be warped. In contrast, by setting the thickness of the niobium carbide layer 30 to 5 µm or less, the internal stress can be reduced, and the warping of the diamond film-deposited substrate 10 can be reduced.
(d) In the diamond film-deposited substrate 10 of this embodiment, the main component of the niobium carbide layer 30 is preferably niobium carbide, for example, having a chemical formula NbC. Thereby, the nucleation density of the diamond crystals for forming the conductive diamond film 40 can be increased.
(e) In the diamond film-deposited substrate 10 of this embodiment, the crystallite size of the niobium carbide contained in the niobium carbide layer 30 is preferably, for example, 1 nm or more and 60 nm or less. When the crystallite size is outside the above range, it may be difficult to form the continuous niobium carbide layer 30 having a thickness of 0.5 µm or more. In contrast, by setting the crystallite size within the above range, the continuous niobium carbide layer 30 having a thickness of 0.5 µm or more is easily formed, and as a result, the occurrence of pinholes is easily suppressed.
(f) In the diamond film-deposited substrate 10 of this embodiment, the crystallite size of the niobium metal contained in the substrate 20 (particularly the niobium metal present in the vicinity of the interface with the niobium carbide layer 30) is preferably, for example, 30 nm or more and 90 nm or less. When the crystallite size of the niobium metal is less than 30 nm, it may be difficult to form the continuous niobium carbide layer 30. In contrast, by setting the crystallite size of the niobium metal to 30 nm or more, the continuous niobium carbide layer 30 is easily formed. On the other hand, when the crystallite size of the niobium metal exceeds 90 nm, the difference in crystallite size with respect to the niobium carbide contained in the niobium carbide layer 30 becomes large, and cracks, etc., may occur. In contrast, by setting the crystallite size of the niobium metal to 90 nm or less, the crystallite size is distributed so as to gradually decrease from the substrate 20 to the niobium carbide layer 30, so the occurrence of cracks, etc., can be suppressed.
(g) A method for manufacturing the diamond film-deposited substrate 10 of this embodiment includes: for example, a process damage layer forming step S102, a carbon source embedding step S103, a niobium carbide layer forming step S105, and a diamond film depositing step S106. This allows the formation of the continuous niobium carbide layer 30, making it possible to suppress the occurrence of pinholes on the surface of the conductive diamond film 40.
(h) According to the method for manufacturing the diamond film-deposited substrate 10 of this embodiment, in the processing damage layer forming step S102, it is preferable to form the processing damage layer 21 having a thickness of, for example, 0.5 µm or more and 5 µm or less (more preferably, 0.8 µm or more and 2.5 µm or less). In the niobium carbide layer forming step S105, at least a portion of the processing damage layer 21 becomes the niobium carbide layer 30, so by setting the thickness of the processing damage layer 21 within the above range, it becomes easier to form the niobium carbide layer 30 with an appropriate thickness.
(i) According to the method for manufacturing the diamond film-deposited substrate 10 of this embodiment, in the niobium carbide layer forming step S105, it is preferable to form the niobium carbide layer 30 having a thickness of, for example, 10% or more and 100% or less (more preferably, 30% or more and 100% or less) of the processing damage layer 21. In other words, it is preferable that a depth range from the surface to 10% or more of the thickness of the processing damage layer 21 is reacted with the carbon source 22 to form the niobium carbide layer 30. When the thickness of the niobium carbide layer 30 is less than 10% of the thickness of the processing damage layer 21, the nucleation density of the diamond crystals will be insufficient, which may cause pinholes. In contrast, by setting the thickness of the niobium carbide layer 30 to 10% or more of the thickness of the processing damage layer 21, the nucleation density of the diamond crystals can be sufficiently increased.
(j) According to the method for manufacturing the diamond film-deposited substrate 10 of this embodiment, in the processing damage layer forming step S102, for example, processing damage is preferably introduced so that the crystallite size of the niobium metal in the processing damage layer 21 is 1 nm or more and 25 nm or less. When the crystallite size of the niobium metal in the processing damage layer 21 exceeds 25 nm, the carbon source 22 is unlikely to diffuse into the processing damage layer 21, and it may be difficult to form the continuous niobium carbide layer 30. In contrast, by setting the crystallite size of the niobium metal in the processing damage layer 21 to 25 nm or less, the surface area of the niobium metal becomes sufficiently large, making it easier to form the continuous niobium carbide layer 30. Further, even when the crystallite size of the niobium metal in the processing damage layer 21 is less than 1 nm, it is possible to form the continuous niobium carbide layer 30. However, it is technically difficult to set the crystallite size of the niobium metal to less than 1 nm, and the cost increases significantly. Therefore, from the viewpoint of cost reduction, the crystallite size of the niobium metal in the processing damage layer 21 is preferably 1 nm or more.
(k) The method for manufacturing the diamond film-deposited substrate 10 of this embodiment includes the seeding step S104. By having diamond particles present at the interface between the niobium carbide layer 30 and the conductive diamond film 40, an energy barrier required for initial nucleation to form the conductive diamond film 40 can be lowered.
(l) The method for manufacturing the diamond film-deposited substrate 10 of this embodiment includes an unevenness forming step S101. Thereby, peeling caused by the difference in thermal expansion coefficient between the substrate 20 and the conductive diamond film 40 can be suppressed. That is, the peel strength of the diamond film-deposited substrate 10 can be improved.

### (4) Modified example of the first embodiment

The above-described embodiment can be modified as required, as in the following modified examples. Hereinafter, only elements different from the above-described embodiment will be described, and elements substantially the same as those described in the above-described embodiment will be given the same reference numerals and their description will be omitted.

FIG. 4 is a schematic view illustrating the cross section of the diamond film-deposited substrate 10 of this modified example. As illustrated in FIG. 4, the diamond film-deposited substrate 10 of this modified example has, for example, a substrate 20, a niobium carbide layer 30, and a conductive diamond film 40, and the niobium carbide layer 30 can be divided into an upper portion 31 and a lower portion 32.

The main component of the upper portion 31 of the niobium carbide layer 30 is niobium carbide having the chemical formula NbC, and the lower portion 32 of the niobium carbide layer 30 contains niobium carbide having the chemical formula Nb₂C. Since the niobium carbide layer 30 is carbonized from the surface side, Nb₂C with a high Nb content is likely to be formed in the lower portion 32 where the amount of carbon source 22 diffusing from the surface side is small. Even when the lower portion 32 of the niobium carbide layer 30 contains NbC as in this modified example, the formation of the continuous niobium carbide layer 30 can sufficiently increase the nucleation density of the diamond crystals for forming the conductive diamond film 40, and can suppress the occurrence of pinholes, resulting in improving the durability of the diamond electrode.

The percentage of the thickness of the upper portion 31 and the lower portion 32 of the niobium carbide layer 30 is not particularly limited, but for example, the thickness of the lower portion 32 of the niobium carbide layer 30 is 50% or more and 150% or less of the thickness of the upper portion 31.

The crystallite size of the niobium carbide contained in the upper portion 31 of the niobium carbide layer 30 is smaller than the crystallite size of the niobium carbide contained in the lower portion 32. Specifically, for example, the crystallite size of the niobium carbide contained in the upper portion 31 is 1 nm or more and 25 nm or less, and the crystallite size of the niobium carbide contained in the lower portion 32 is, for example, 20 nm or more and 60 nm or less. The crystallite size of the niobium carbide contained in the upper portion 31 was calculated from the peak of NbC (111) in XRD, and the crystallite size of the niobium carbide contained in the lower portion 32 was calculated from the peak of Nb₂C (211) in XRD.

In the niobium carbide layer forming step S105 of this modified example, the main component of the upper portion 31 of the niobium carbide layer 30 is niobium carbide having the chemical formula NbC, and the niobium carbide layer 30 is formed such that the lower portion 32 of the niobium carbide layer 30 contains niobium carbide having the formula Nb₂C. The smaller the crystallite size of the niobium metal, the easier it is to carbonize and form NbC. Therefore, when forming the niobium carbide layer 30 as in this modified example, for example, in the processing damage layer forming step S102, processing damage may be introduced so that the crystallite size of the niobium metal in the upper portion of the processing damage layer 21 is smaller than the crystallite size of the niobium metal in the lower portion thereof.

### <Other embodiments of the present invention>

Although the embodiment of the present invention has been specifically described above, the present invention is not limited to the above-described embodiment, and various modifications can be made without departing from the gist of the present invention.

For example, in the above embodiment, each step of the method for manufacturing the diamond film-deposited substrate 10 has been described, but it is not necessary to perform all of the steps described above. Specifically, for example, one (or both) of the unevenness forming step S101 and the seeding step S104 may be omitted. In this case also, similarly to the first embodiment, the continuous niobium carbide layer 30 is formed, and pinholes in the conductive diamond film 40 can be suppressed.

In the above embodiment, the carbon source 22 is embedded inside the microcracks with voids in the carbon source embedding step S103. However, it is not always necessary to form microcracks with voids and embed the carbon source 22 inside the microcracks. For example, by making the crystallite size of the niobium metal in the processing damage layer 21 sufficiently small (for example, 20 nm or less), it is possible to form a large number of grain boundaries (microcracks without voids) where crystal defects are densely gathered and arranged. Thereby, a diffusion path of the carbon source 22 can be sufficiently secured and the surface area of the niobium metal that contributes to the carbonization reaction can be sufficiently increased. Therefore, even when the carbon source 22 is not embedded inside the microcracks but is introduced to be in contact with the surface of the processing damage layer 21, the niobium carbide layer 30 can be formed. The carbon source 22 diffuses into the inside of the niobium metal through grain boundaries (microcracks without voids) even when it is not embedded inside the microcracks with voids. Therefore, it is possible to obtain a niobium carbide layer 30 having a thickness according to the diffusion length. However, from the viewpoint of facilitating the formation of the continuous niobium carbide layer 30 having a sufficient thickness (for example, 0.5 µm or more), as in the above embodiment, it is preferable to embed the carbon source 22 inside the microcracks with voids.

Further, the above-described embodiment shows a case in which the conductive diamond film 40 has a single layer structure. However, the conductive diamond film 40 may have a layered structure in which a plurality of conductive diamond layers are stacked. However, according to the present invention, even when the conductive diamond film 40 has a single-layer structure as in the above-described embodiment, the occurrence of pinholes can be suppressed.

### Examples

Next, examples of the present invention will be described. These examples are merely examples of the present invention, and the present invention is not limited to these examples.

### (1) Manufacturing of the diamond film-deposited substrate 10

### (Sample 1)

First, the diamond film-deposited substrate 10 of Sample 1 was manufactured by the following procedure.

A substrate 20 comprising niobium metal was prepared and subjected to grinding process. For the grinding process, a vertical shaft round table type device was used, and a grindstone made of cubic boron carbide (grain size #600 or more) was used. It was confirmed by a scanning electron microscope that a processing damage layer 21 having microcracks was formed on the main surface of the substrate 20 after the grinding process.

After the grinding process, the main surface of the substrate 20 was sprinkled with 7.5 mg/cm² of graphite (particle size 1 to 2 µm) as the carbon source 22, and the surface was rubbed against another substrate 20 of the same size. The amount of embedded graphite was measured before and after embedding, and it was confirmed that 2.1 µg/cm² of graphite (grain size 5 to 45 nm) was embedded inside the processing damage layer 21 after rubbing. When the main surface of the substrate 20 was measured by XRD, the crystallite size of the niobium metal in the processing damage layer 21 was 12.3 nm.

In these examples, the crystallite sizes were calculated from the results of wide-angle X-ray diffraction measurement using an X-ray diffractometer (RINT2500HLB) manufactured by Rigaku Corporation. The measurement conditions were as follows:
Measurement wavelength: CuKα (0.15418 nm)
X-ray output: 50 kV-250 mA
Optical system: Parallel beam with monochromator
Divergence slit (DS): 0.5° + 10 mmH
Scattering slit (SS): 0.5°
Receiving slit (RS): 0.15 mm
Scan axis: 2θ/θ
Scanning method: Continuous scanning
Scanning range: 5° ≦ 2 *θ* ≦ 100°
Scanning speed: 0.5°/min
Sampling: 0.01°

The substrate 20 with the graphite embedded therein was placed in a hot filament CVD apparatus, and the formation of the niobium carbide layer 30 and the deposition of the conductive diamond film 40 were performed successively. Specifically, hydrogen gas, methane gas, and TMB gas were introduced, and a pressure was set to 20 to 50 Torr. Thereafter, a voltage (120 to 150 V) was applied to the 40 cm filament and maintained until the filament was carbonized and the resistance became constant. Further, the filament voltage was increased to 175V, and a filament temperature was kept at 2200 to 2400°C and a substrate temperature was kept at 700 to 800°C for 180 minutes.

The diamond film-deposited substrate 10 was removed from the hot filament CVD apparatus, and it was confirmed that the conductive diamond film 40 with a thickness of 3.32 µm had been deposited thereon. Further, when the diamond film-deposited substrate 10 was measured from the conductive diamond film 40 side by XRD, the crystallite size of the niobium metal was 85.6 nm, and the crystallite size of the niobium carbide was 1.9 nm.

### (Sample 2)

Further, the diamond film-deposited substrate 10 of Sample 2 was manufactured by the following procedure.

The substrate 20 comprising niobium metal was prepared, and subjected to the same grinding process as in Sample 1. It was confirmed by a scanning electron microscope that the processing damage layer 21 having microcracks was formed on the main surface of the substrate 20 after the grinding process.

In Sample 2, the carbon source 22 was not embedded, and the substrate 20 after grinding was placed in a hot filament CVD apparatus, and the formation of the niobium carbide layer 30 and the deposition of the conductive diamond film 40 were performed successively under the same conditions as those for Sample 1.

The diamond film-deposited substrate 10 was removed from the hot filament CVD apparatus, and it was confirmed that the conductive diamond film 40 with a thickness of 2.72 µm had been deposited thereon. Further, when the diamond film-deposited substrate 10 was measured from the conductive diamond film 40 side by XRD, the crystallite size of the niobium metal was 33.0 nm, and the crystallite size of the niobium carbide was 6.9 nm.

### (Sample 3)

Further, the diamond film-deposited substrate 10 of Sample 3 was manufactured by the following procedure.

In Sample 3, without forming the processing damage layer 21, graphite (particle size 1 to 2 µm) was sprinkled as a carbon source 22 in an amount of 7.5 mg/cm² on the main surface of a substrate 20 comprising metal niobium, and the surface was rubbed against another substrate 20 of the same size. It was confirmed that 1.2 µg/cm² of graphite was adhered to the surface of the substrate 20 after rubbing. When the main surface of the substrate 20 was measured by XRD, the crystallite size of the niobium metal was 26.1 nm.

The substrate 20 after rubbing was placed in a hot filament CVD apparatus, and under the same conditions as those for sample 1, the formation of the niobium carbide layer 30 and the deposition of the conductive diamond film 40 were performed successively.

The diamond film-deposited substrate 10 was removed from the hot filament CVD apparatus, and it was confirmed that the conductive diamond film 40 with a thickness of 2.94 µm had been deposited thereon. Further, when the diamond film-deposited substrate 10 was measured from the conductive diamond film 40 side by XRD, the crystallite size of the niobium metal was 58.1 nm, and the crystallite size of the niobium carbide was 25.7 nm.

### (Sample 4)

Further, the diamond film-deposited substrate 10 of Sample 4 was manufactured by the following procedure.

The substrate 20 comprising metal niobium was prepared and subjected to blast processing. For the blast processing, a silicon carbide (grain size #100) shot material was used. It was confirmed by a scanning electron microscope that a processing damage layer 21 having microcracks was formed on the main surface of the substrate 20 after the grinding process.

After the blasting process, the main surface of the substrate 20 was sprinkled with 7.5 mg/cm² of graphite (particle size 1 to 2 µm) as the carbon source 22, and the surface was rubbed against another substrate 20 of the same size. The amount of the embedded graphite was measured before and after embedding, and it was confirmed that 5.3 µg/cm² of graphite (grain size 5 to 70 nm) was embedded inside the processing damage layer 21 after rubbing. When the main surface of the substrate 20 was measured by XRD, the crystallite size of the niobium metal in the processing damage layer 21 was 6.9 nm.

The substrate 20 with the graphite embedded therein was placed in a hot filament CVD apparatus, and under the same conditions as those for sample 1, the formation of the niobium carbide layer 30 and the deposition of the conductive diamond film 40 were performed successively.

The diamond film-deposited substrate 10 was removed from the hot filament CVD apparatus, and it was confirmed that the conductive diamond film 40 with a thickness of 3.21 µm had been deposited thereon. Further, when the diamond film-deposited substrate 10 was measured from the conductive diamond film 40 side by XRD, the crystallite size of the niobium metal was 63.1 nm, and the crystallite size of the niobium carbide was 12.8 nm.

### (2) Evaluation of the diamond film-deposited substrate 10

The cross sections of Samples 1 to 4 were observed using a scanning electron microscope. In sample 2 in which the carbon source 22 was not embedded and sample 3 in which the processing damage layer 21 was not formed, niobium carbide formed in an island shape was observed at the interface between the substrate 20 and the conductive diamond film 40, and a continuous niobium carbide layer 30 was not formed. In contrast, in Sample 1 and Sample 4, in which the processing damage layer 21 was formed and the carbon source 22 was embedded in the processing damage layer 21, the continuous niobium carbide layer 30 was formed at the interface between the substrate 20 and the conductive diamond film 40.

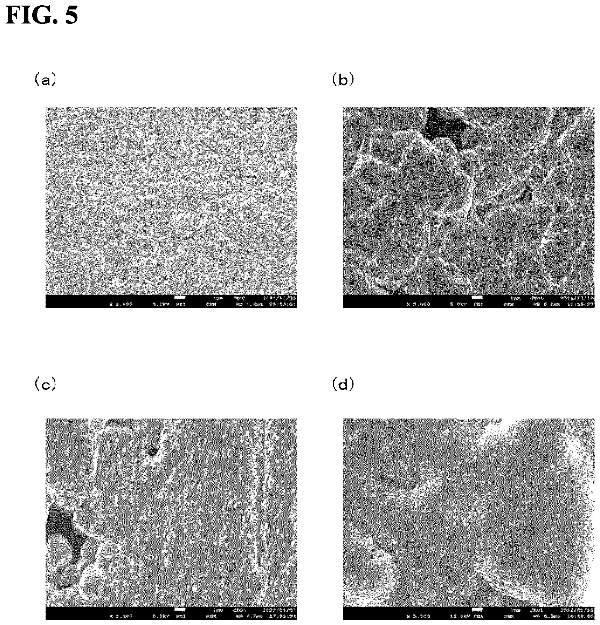

Further, for Samples 1 to 4, the surface of the conductive diamond film 40 was observed using a scanning electron microscope. A surface photograph of Sample 1 is shown in FIG. 5(a), a surface photograph of Sample 2 is shown in FIG. 5(b), a surface photograph of Sample 3 is shown in FIG. 5(c), and a surface photograph of Sample 4 is shown in FIG. 5(d).

As shown in FIG. 5(b) and FIG. 5(c), in Sample 2 in which the carbon source 22 was not embedded and Sample 3 in which the processing damage layer 21 was not formed, pinholes were observed on the surface of the conductive diamond film 40. In contrast, as shown in FIG. 5(a) and FIG. 5(d), in Sample 1 and Sample 4, in which the processing damage layer 21 was formed and the carbon source 22 was embedded in the processing damage layer 21, no pinholes were observed on the surface of the conductive diamond film 40.

As described above, it was confirmed that the processing damage layer 21 having microcracks was formed on the main surface of the substrate 20, and the carbon source 22 was embedded inside the processing damage layer 21, thereby forming the continuous niobium carbide layer 30. It was also confirmed that due to the formation of the continuous niobium carbide layer 30, the occurrence of pinholes on the surface of the conductive diamond film 40 could be suppressed.

### (3) Durability test of the diamond electrode

The diamond electrodes fabricated from the diamond film-deposited substrates 10 of Samples 1 to 4 were used as the anode and cathode, respectively, to perform a durability test for generating ozone water. Nafion 324 (manufactured by Du Pont) was used as a polymer electrolyte membrane. Tap water (flow rate 200 mL/min) was used as raw water, and a cycle of driving for 8 minutes at a low voltage of 15 V and then pausing for 2 minutes was repeated 1000 times. Thereafter, the diamond electrode was taken out and an area percentage of the peeled-off conductive diamond film 40 was confirmed. The results are shown in Table 1.

**[Table 1]**

| Sample name | Ozone water concentration at first cycle (ppm) | Ozone water concentration after 1000 cycles (ppm) | Peeling area ratio after 1000 cycles |
|---|---|---|---|
| Sample 1 | 11.3 | 10.8 | 0% |
| Sample 2 | 9.3 | 1.5 | About 80% |
| Sample 3 | 8.3 | 1.0 | About 90% |
| Sample 4 | 12.1 | 11.5 | 0% |

As shown in Table 1, in Sample 2 in which the carbon source 22 was not embedded and in Sample 3 in which the processing damage layer 21 was not formed, the ozone water concentration at the 1000th cycle was significantly lower than that at the first cycle, and degradation due to electrical current was confirmed. Further, peeling of the conductive diamond film 40 was also confirmed. In contrast, in Sample 1 and Sample 4, in which the processing damage layer 21 was formed and the carbon source 22 was embedded in the processing damage layer 21, even after 1000 cycles, the ozone water concentration was the same (95% or more) as that after the first cycle. Further, no peeling of the conductive diamond film 40 was observed.

As described above, it was confirmed that by forming the continuous niobium carbide layer 30 and suppressing the occurrence of pinholes on the surface of the conductive diamond film 40, deterioration due to electrical current could be suppressed and peeling of the conductive diamond film 40 could be prevented. That is, it was confirmed that the durability of the diamond electrode was improved.

### <Preferable aspects of the present invention>

### (Supplementary description 1)

According to an aspect of the present invention, there is provided a diamond film-deposited substrate, including:
a substrate comprising niobium metal;
a niobium carbide layer on at least one main surface of the substrate; and
a conductive diamond film on the niobium carbide layer,
wherein when a surface of the conductive diamond film is observed using a scanning electron microscope, no pinholes reaching the substrate or the niobium carbide layer are present within a field of view of 20 µm×20 µm.

Particularly preferably, no pinholes reaching the substrate or the niobium carbide layer are present over an entire surface of the conductive diamond film.

### (Supplementary description 2)

There is provided the diamond film-deposited substrate according to the supplementary description 1,
wherein when a cross section of the diamond film-deposited substrate is observed with a scanning electron microscope, a continuous niobium carbide layer having a thickness of 0.5 µm or more is provided over a width of 20 µm or more.

More preferably, a continuous niobium carbide layer having a thickness of 0.5 µm or more is provided over a width of 1 mm or more.

Particularly preferably, a continuous niobium carbide layer having a thickness of 0.5 µm or more is provided on an entire main surface.

### (Supplementary description 3)

There is provided the diamond film-deposited substrate according to the supplementary description 1 or 2,
wherein the niobium carbide layer has a thickness of 0.5 µm or more and 5 µm or less.

More preferably, the niobium carbide layer has a thickness of 0.8 µm or more and 2.5 µm or less.

### (Supplementary description 4)

There is provided the diamond film-deposited substrate according to any one of the supplementary descriptions 1 to 3,
wherein a main component of the niobium carbide layer is niobium carbide having a chemical formula NbC.

### (Supplementary description 5)

There is provided the diamond film-deposited substrate according to any one of the supplementary descriptions 1 to 4,
wherein a main component of an upper portion of the niobium carbide layer is niobium carbide having a chemical formula NbC, and a lower portion of the niobium carbide layer comprises niobium carbide having a chemical formula Nb₂C.

### (Supplementary description 6)

There is provided the diamond film-deposited substrate according to any one of the supplementary descriptions 1 to 5,
wherein a crystallite size of the niobium carbide contained in the niobium carbide layer is 1 nm or more and 60 nm or less.

### (Supplementary description 7)

There is provided the diamond film-deposited substrate according to any one of the supplementary descriptions 1 to 6,
wherein a crystallite size of the niobium metal is 30 nm or more and 90 nm or less.

### (Supplementary description 8)

There is provided a method for manufacturing a diamond film-deposited substrate, the method including:
forming a processing damage layer having microcracks by introducing processing damage onto at least one main surface of a substrate comprising niobium metal;
embedding a carbon source comprising a solid carbon or carbon compound into the processing damage layer;
applying a heat treatment to the processing damage layer to cause a reaction between the niobium metal and the carbon source to form a niobium carbide layer continuously covering the main surface; and
depositing a conductive diamond film on the niobium carbide layer.

### (Supplementary description 9)

There is provided the method for manufacturing a diamond film-deposited substrate according to the supplementary description 8,
wherein in the forming the processing damage layer, a processing damage layer having a thickness of 0.5 µm or more and 5 µm or less is formed.
more preferably, a processing damage layer having a thickness of 0.8 µm or more and 2.5 µm or less is formed.

### (Supplementary description 10)

There is provided the method for manufacturing a diamond film-deposited substrate according to the supplementary description 8 or 9,
wherein in the forming the niobium carbide layer, a niobium carbide layer having a thickness that is 10% or more and 100% or less of the processing damage layer is formed.
more preferably, a niobium carbide layer having a thickness of 30% or more and 100% or less of the processing damage layer is formed.

### (Supplementary description 11)

There is provided the method for manufacturing a diamond film-deposited substrate according to any one of the supplementary descriptions 8 to 10,
wherein in the forming the processing damage layer, processing damage is introduced so that a crystallite size of the niobium metal in the processing damage layer is 1 nm or more and 25 nm or less.

### (Supplementary description 12)

There is provided the method for manufacturing a diamond film-deposited substrate according to any one of the supplementary descriptions 8 to 11,
wherein the method further includes seeding the main surface with diamond particles before forming the niobium carbide layer.

### (Supplementary description 13)

There is provided the method for manufacturing a diamond film-deposited substrate according to any one of the supplementary descriptions 8 to 12,
wherein the method further includes performing processing to form unevenness on the main surface before forming the processing damage layer.

### (Supplementary description 14)

There is provided a method for manufacturing a diamond film-deposited substrate according to any one of the supplementary descriptions 8 to 13,
wherein in the forming the niobium carbide layer, a niobium carbide layer containing niobium carbide of a chemical formula NbC as a main component is formed.

### (Supplementary description 15)

There is provided a method for manufacturing a diamond film-deposited substrate according to any one of the supplementary descriptions 8 to 13,
wherein in the forming the niobium carbide layer, the niobium carbide layer is formed so that a main component of an upper portion of the niobium carbide layer is niobium carbide having a chemical formula NbC, and a lower portion of the niobium carbide layer contains niobium carbide having a chemical formula Nb₂C.

### (Supplementary description 16)

There is provided a method for manufacturing a diamond film-deposited substrate according to any one of the supplementary descriptions 8 to 15,
wherein in the forming the niobium carbide layer, the niobium carbide layer is formed so that a crystal grain size of niobium carbide contained in the niobium carbide layer is 1 nm or more and 60 nm or less.

### Description of signs and numerals

10 Diamond film-deposited substrate
20 Substrate
21 Processing damage layer
22 Carbon source
30 Niobium carbide layer
31 Upper portion
32 Lower portion
40 Conductive diamond film
S101 Unevenness forming step
S102 Processing damage layer forming step
S103 Carbon source embedding step
S104 Seeding step
S105 Niobium carbide layer forming step
S106 Diamond film depositing step

## Claims

1. According to an aspect of the present invention, there is provided a diamond film-deposited substrate, comprising:
a substrate comprising niobium metal;
a niobium carbide layer on at least one main surface of the substrate; and
a conductive diamond film on the niobium carbide layer,
wherein when a surface of the conductive diamond film is observed using a scanning electron microscope, no pinholes reaching the substrate or the niobium carbide layer are present within a field of view of 20 µm×20 µm.

2. The diamond film-deposited substrate according to claim 1,
wherein when a cross section of the diamond film-deposited substrate is observed with a scanning electron microscope, a continuous niobium carbide layer having a thickness of 0.5 µm or more is provided over a width of 20 µm or more.

3. The diamond film-deposited substrate according to claim 1, wherein the niobium carbide layer has a thickness of 0.5 µm or more and 5 µm or less.

4. The diamond film-deposited substrate according to claim 1,
wherein a main component of the niobium carbide layer is niobium carbide having a chemical formula NbC.

5. The diamond film-deposited substrate according to claim 1,
wherein a main component of an upper portion of the niobium carbide layer is niobium carbide having a chemical formula NbC, and a lower portion of the niobium carbide layer comprises niobium carbide having a chemical formula Nb₂C.

6. The diamond film-deposited substrate according to claim 1,
wherein a crystallite size of the niobium carbide contained in the niobium carbide layer is 1 nm or more and 60 nm or less.

7. The diamond film-deposited substrate according to any one of claims 1 to 6,
wherein a crystallite size of the niobium metal is 30 nm or more and 90 nm or less.

8. A method for manufacturing a diamond film-deposited substrate, the method including:
forming a processing damage layer having microcracks by introducing processing damage onto at least one main surface of a substrate comprising niobium metal;
embedding a carbon source comprising a solid carbon or carbon compound into the processing damage layer;
applying a heat treatment to the processing damage layer to cause a reaction between the niobium metal and the carbon source to form a niobium carbide layer continuously covering the main surface; and
depositing a conductive diamond film on the niobium carbide layer.

9. The method for manufacturing a diamond film-deposited substrate according to claim 8,
wherein in the forming the processing damage layer, a processing damage layer having a thickness of 0.5 µm or more and 5 µm or less is formed.

10. The method for manufacturing a diamond film-deposited substrate according to claim 8,
wherein in the forming the niobium carbide layer, a niobium carbide layer having a thickness that is 10% or more and 100% or less of the processing damage layer is formed.

11. The method for manufacturing a diamond film-deposited substrate according to claim 8,
wherein in the forming the processing damage layer, processing damage is introduced so that a crystallite size of the niobium metal in the processing damage layer is 1 nm or more and 25 nm or less.

12. The method for manufacturing a diamond film-deposited substrate according to claim 8,
wherein the method further includes seeding the main surface with diamond particles before forming the niobium carbide layer.

13. The method for manufacturing a diamond film-deposited substrate according to any one of claims 8 to 12,
wherein the method further includes performing processing to form unevenness on the main surface before forming the processing damage layer.
